# EUROPÄISCHE PATENTANMELDUNG

(11) **EP 2 682 230 A2**
(43) Veröffentlichungstag der Anmeldung: **08.01.2014**
(21) Anmeldenummer: 13172466.8
(22) Anmeldetag: 18.06.2013
(51) Int. Cl.: B24B 19/12, B24C 1/08, B23K 26/00, C23C 14/06, F01L 1/16, F16H 53/00, B21D 53/84, F01L 1/047, B23P 13/00

(54) **Verfahren zur Herstellung/Bearbeitung eines Nockens**

(30) Priorität: 06.07.2012 DE 102012211864
(71) Anmelder: MAHLE International GmbH, 70376 Stuttgart (DE)
(72) Erfinder: Flender, Thomas, 71735 Eberdingen (DE); Schneider, Falk, 70825 Korntal-Münchingen (DE); Baitinger, Gert, 70176 Stuttgart (DE)
(74) Vertreter: BRP Renaud & Partner

(57) **Zusammenfassung**

Die vorliegende Erfindung betrifft ein Verfahren zur Bearbeitung bzw. Herstellung eines Nockens (3) einer Nockenwelle (1), der eine außenliegende Nockenlauffläche (6) aufweist, welche mit amorphem Kohlenstoff beschichtet ist. Erfindungswesentlich ist dabei, dass die mit amorphem Kohlenstoff beschichtete Nockenlauffläche (6) feinstbearbeitet wird.

Die Erfindung betrifft des Weiteren einen Nocken (3) einer Nockenwelle (1), der gemäß dem erfindungsgemäßen Verfahren hergestellt bzw. bearbeitet ist.

## Beschreibung

Die vorliegende Erfindung betrifft Verfahren zur Herstellung bzw. Bearbeitung eines Nockens einer Nockenwelle gemäß dem Oberbegriff des Anspruchs 1 sowie einen Nocken, der gemäß einem solchen Verfahren hergestellt bzw. bearbeitet ist.

Ein Nocken ist üblicherweise Bestandteil einer Nockenwelle, die beispielsweise bei einer Brennkraftmaschine eines Fahrzeuges zum Einsatz kommt. Die Nockenwelle kann hierbei mehrere solche Nocken aufweisen, mit deren Hilfe die Ventile betätigt werden können. Hierzu ist der Nocken üblicherweise mit einem Nockenberg versehen, wobei eine außenliegende Nockenlauffläche entlang des zu betätigenden Ventilhebels gleiten kann, um den Hebel bzw. das Ventil durch die exzentrische Ausbildung zu betätigen. Hierbei wird der Nocken mit Hilfe der Welle rotiert, wobei der Nocken eine Öffnung aufweist, die dem Verbinden des Nockens mit der Welle der Nockenwelle dient. Um Reibungseffekte zwischen den Nocken und eines zu betätigenden Bauteiles, also insbesondere des Ventils oder des Hebels, zu reduzieren, können der Nocken, insbesondere die Nockenlauffläche und/oder das Bauteils, geschmiert sein.

Ferner ist es vorstellbar, die Nockenlauffläche mit einem reibungsreduzierendenund verschleißfestem Material wie beispielsweise amorphen Kohlenstoff, insbesondere mit Diamond-like Carbon (DLC), zu beschichten. Derartige Nocken sind beispielweise aus der DE 41 27 639 A1, der DE 44 18 245 A1, der DE 603 04 652 T2, der DE 10 2005 045 290 A1 sowie der EP 1 505 266 A2 bekannt.

Weiter solche Nocken sind aus der EP 1 554 469 B1 oder der EP 1 967 703 B1 und der US 2004/231622 A1 bekannt.

Die vorliegende Erfindung beschäftigt sich mit dem Problem, für ein Verfahren zur Herstellung bzw. Bearbeitung eines Nockens und für einen derartigen Nocken der gattungsgemäßen Art eine verbesserte oder zumindest alternative Ausführungsform anzugeben, die sich insbesondere durch einen verringerten Verschleiß und/oder eine reduzierte Reibung zwischen dem Nocken und des zu betätigenden Bauteils auszeichnet.

Dieses Problem wird erfindungsgemäß durch die Gegenstände der unabhängigen Ansprüche gelöst. Vorteilhafte Ausführungsformen sind Gegenstand der abhängigen Ansprüche.

Bei der Untersuchung der mit amorphem Kohlenstoff beschichteten Nockenlauffläche wurde überraschenderweise festgestellt, dass diese mit amorphem Kohlenstoff beschichtete Nockenlauffläche, also insbesondere die Oberfläche des amorphen Kohlenstoffes, Unebenheiten bzw. Spitzen aufweist, welche zu einer erhöhten Reibung zwischen dem Nocken, insbesondere der Nockenlauffläche, und dem zu betätigenden Bauteil, also dem Hebel bzw. dem Ventil, führen. Ferner können derartige Spitzen auch zur Beschädigung, etwa in Form von Kratzern, des zu betätigenden Bauteils führen. Derartige Spitzen können dabei Dimensionen im Bereich von Mikrometern aufweisen.

Die vorliegende Erfindung beruht deshalb auf dem allgemeinen Gedanken, die mit amorphem Kohlenstoff, insbesondere DLC, beschichtete Nockenlauffläche zumindest bereichsweise durch eine Feinstbearbeitung zu glätten, um insbesondere besagte Spitzen zu beseitigen bzw. ihre Anzahl zu reduzieren und/oder ihre Dimensionen zu reduzieren. Dies führt insbesondere zu einer reduzierten Reibung zwischen der mit amorphem Kohlenstoff beschichteten Nockenlauffläche und dem zu betätigenden Bauteil, wodurch einerseits ein reduzierter Verschleiß und andererseits ein verbessertes Gleiten der Nockenlauffläche entlang des Bauteiles erreicht werden kann.

Unter Feinstbearbeitung sind hier Verfahren zu verstehen, durch die die Oberflächengüte des amorphen Kohlenstoffes bzw. der Nockenlauffläche verbessert wird. Bei der Feinstbearbeitung handelt es sich also insbesondere um Superfinish-Verfahren bzw. eine Oberflächenmikrobehandlung, bei denen insbesondere die Spitzenhöhe der Oberfläche verringert wird.

Bei der Feinstbearbeitung können im Allgemeinen beliebige Werkzeuge bzw. Verfahren zum Einsatz kommen. Insbesondere kann die mit amorphem Kohlenstoff beschichte Nockenlauffläche bei der Feinstbearbeitung geschliffen, gehont, poliert und dergleichen werden. Zudem kann die Feinstbearbeitung auch die Bearbeitung durch Kugelstrahlen beinhalten. Auch sind Ausführungsformen vorstellbar, bei denen eine Kombination der besagten Bearbeitungen bzw. Verfahren zum Einsatz kommen. Als Beispiele für Schleifverfahren wird hier auf Gleitschleifen bzw. Langschleifen und Querschleifen hingewiesen. Ferner kann das Honen der mit amorphem Kohlenstoff beschichteten Nockenlauffläche das Langhubhonen bzw. das Flachhonen beinhalten.

Es versteht sich, dass nicht die gesamte Nockenlauffläche mit amorphem Kohlenstoff beschichtet sein muss. Ebenso können auch nur Abschnitte der Nockenlauffläche mit amorphem Kohlenstoff beschichtet sein, wobei einer oder mehrere dieser Abschnitte erfindungsgemäß zumindest bereichsweise feinstbearbeitet werden.

Bei bevorzugten Ausführungsformen wird auf die Nockenlauffläche eine Struktur, insbesondere eine Mikrostruktur, aufgebracht. Dabei zeichnet sich eine solche Mikrostruktur dadurch aus, dass Strukturelemente der Mikrostruktur Dimensionen, insbesondere Tiefen, im Bereich von Mikrometern aufweisen. Insbesondere können derartige Strukturelemente Tiefen zwischen 2 µm und 20 µm aufweisen. Das Versehen der Nockenlauffläche mit der Struktur, insbesondere mit der Mikrostruktur, dient hierbei insbesondere dem Zweck, ein Speicher bzw. ein Reservoir zu schaffen, in dem ein Schmierstoff bzw. Schmiermittel, also insbesondere Schmieröl, gespeichert werden kann, um die Reibung zwischen der Nockenlauffläche und des zu betätigenden Bauteiles zu verbessern und/oder das Gleiten der Nockenlauffläche entlang des zu betätigenden Bauteiles zu verbessern. Dies kann insbesondere bei einem geringen Angebot an Schmieröl besonders vorteilhaft sein.

Die Struktur, insbesondere die Mikrostruktur, kann hierbei bereits vor dem Beschichten der Nockenlauffläche mit amorphem Kohlenstoff auf die Nockenlauffläche aufgebracht werden.

Bei anderen Ausführungsformen wird die Struktur auf die mit amorphem Kohlenstoff beschichtete Nockenlauffläche aufgebracht. Bei alternativen Ausführungsformen wird die Struktur auf die mit amorphem Kohlenstoff beschichtete und feinstverarbeitete Nockenlauffläche aufgebracht. Bei beiden Varianten wird die Nockenlauffläche vorzugsweise nach dem Aufbringen der Struktur feinstbearbeitet. Wird die Struktur also auf die mit amorphem Kohlenstoff beschichtete und feinstbearbeitete Nockenlauffläche aufgebracht, so wird die Nockenlauffläche nach dem Aufbringen der Struktur erneut feinstbearbeitet. Das Aufbringen der Struktur auf die Nockenlauffläche muss hierbei nicht zwingend auf die gesamte Nockenlauffläche bzw. auf die gesamte mit amorphem Kohlenstoff beschichtete Nockenlauffläche erfolgen. Insbesondere kann das Aufbringen der Struktur auf vorteilhafte Bereiche reduziert werden. So kann die Struktur, insbesondere die Mikrostruktur, lediglich in den Bereichen aufgebracht werden, in denen eine Speicherung von Schmiermittel bzw. Schmierstoff erwünscht bzw. benötigt ist. Dies kann insbesondere der Bereich der Nockenlauffläche sein, der im berührenden Kontakt mit anderen Ventiltriebselementen ist.

Das Aufbringen der Struktur kann prinzipiell beliebig erfolgen, sofern die erwünschten Dimensionen und/oder Formen der Struktur erreicht werden können. So kann das Aufbringen der Struktur insbesondere im Zuge der Feinstbearbeitung erfolgen. Auch kann die Struktur anderweitig und auf bekannter Weise mechanisch aufgebracht werden. Bei weiteren Varianten kann die Struktur mittels einer Lasereinrichtung aufgebracht werden, die eine oder zwei oder mehrere Laser aufweist, welche die Nockenlauffläche entsprechend bearbeiten. Auch kann die Struktur mit Hilfe einer Elektronenstrahleinrichtung aufgebracht werden, welche die Nockenlauffläche mit Hilfe eines Elektronenstrahles oder mehrerer Elektronenstrahlen bearbeitet.

Die Struktur kann ferner eine beliebige Form aufweisen. So kann die Struktur insbesondere regelmäßig aufgebracht werden bzw. eine regelmäßige Form aufweisen. Hierzu kann die Struktur insbesondere Strukturelemente aufweisen, die entsprechend regelmäßig angeordnet sind. Derartige Strukturelemente weisen bei bevorzugten Ausführungsformen eine linienartige Form auf. Hierbei können die jeweiligen Strukturelemente regelmäßig, geordnet oder ungeordnet, auf die Nockenlauffläche aufgebracht werden. Zudem können die Strukturelemente derart auf die Nockenlauffläche aufgebracht werden, dass sie sich berühren bzw. schneiden oder voneinander beabstandet verlaufen. Selbstverständlich sind auch Ausführungsformen vorstellbar, bei denen die Strukturelemente der Struktur bzw. die Struktur als solche unregelmäßig auf die Nockenlauffläche aufgebracht werden/wird.

In einer weiteren Ausführungsform sind die Strukturelemente in Form von einzelnen Strukturpunkten, insbesondere vertieften Kratern, in vordefiniertem Abstand, teilweise aber nicht zwingend überlappend, auf die Nockenlauffläche aufgebracht.

Bei besonders vorteilhaften Ausführungsformen werden die Strukturelemente derart aufgebracht, dass sie schräg zu einer Achse des Nockens verlaufen. Insbesondere verlaufen die Strukturelemente in einem Winkel zwischen 60° und 90° zur Achse des Nockens. Vorteilhaft entspricht die Ausrichtung des Nockens einer Richtung, entlang der die Nockenlauffläche des Nockens am zu betätigenden Bauteil gleitet bzw. der Richtung entlang der sich der Nocken bzw. die Nockenlauffläche relativ zum betätigenden Bauteil bewegt. Eine solche Richtung ist also insbesondere eine Anschlepprichtung des Nockens. Hierdurch ist insbesondere bezweckt, das Schmiermittel bzw. Schmieröl in der Struktur, insbesondere in der Mikrostruktur, gespeichert werden kann, um, wie zuvor erwähnt, die Reibung zwischen dem Nocken, insbesondere der Nockenlauffläche, und dem zu betätigenden Bauteil zu verringern und/oder das Gleiten des Nockens, insbesondere der Nockenlauffläche, entlang des zu betätigenden Bauteils zu verbessern.

Vorteilhaft wird durch die Feinstbearbeitung eine Autokorrelationslänge Sal der Nockenlauffläche vergrößert. Dabei ist die Autokorrelationslänge Sal insbesondere gemäß der Norm ISO 25178-2 definiert. Ganz bevorzugt wird die Feinstbearbeitung derartig angewendet, dass die Autokorrelationslänge Sal der bearbeiteten Nockenlauffläche verdoppelt wird.

Bei weiteren bevorzugten Ausführungsformen wird die Feinstbearbeitung derart angewendet, dass eine Spitzendichte der Oberfläche Spd der bearbeiteten Nockenlauffläche verkleinert wird. Hierbei handelt es sich insbesondere um die die Struktur aufweisende Nockenlauffläche. Ferner ist die Spitzendichte der Oberfläche Spd vorzugsweise ebenfalls gemäß der Norm ISO 25178-2 definiert. Bei besonders bevorzugten Ausführungsformen wird die Spitzendichte der Oberfläche Spd durch die Feinstbearbeitung um zumindest 10 % verkleinert.

Es versteht sich, dass auch ein Nocken einer Nockenwelle, der gemäß dem erfindungsgemäßen Verfahren hergestellt bzw. erarbeitet ist, als Solcher zum Gegenstand der Erfindung gehört.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Bauteile beziehen.

Es zeigen, jeweils schematisch
- Fig. 1: einen Schnitt durch eine Nockenwelle,
- Fig. 2: eine räumliche Ansicht eines Nockens,
- Fig. 3: eine Seitenansicht eines Nockens.

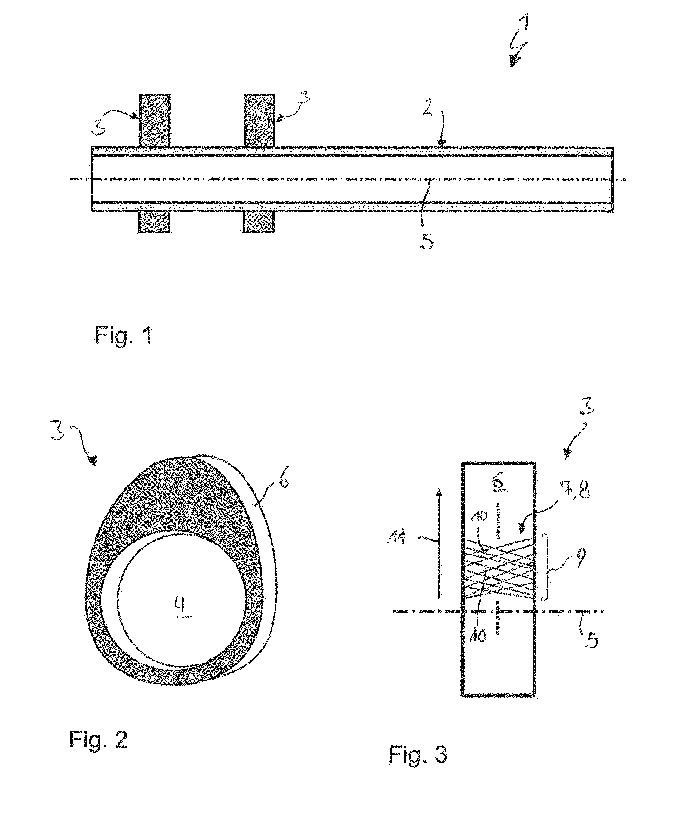

Fig. 1 zeigt einen Längsschnitt durch eine Nockenwelle 1, die im gezeigten Beispiel eine Welle 2 sowie zwei Nocken 3 umfasst. Der jeweilige Nocken 3 ist mit der als Hohlwelle ausgestalteten Welle 2 der Nockenwelle 1 drehfest verbunden. Hierzu weist der jeweilige Nocken 3, wie in Fig. 2 gezeigt, eine Öffnung 4 auf, in der die Welle 2 angeordnet ist. Die Verbindung zwischen der Welle 2 und dem jeweiligen Nocken 3 kann beispielsweise durch einen Quersitz oder einen Längssitz realisiert sein. Beim mit der Welle 2 verbundenen Zustand des Nockens 3 verläuft eine Längsmittelachse bzw. Drehachse 5 der Welle 2 mittig durch die runde Öffnung 4 des jeweiligen Nockens 3, wobei der Nocken 3 exzentrisch ausgebildet ist, das heißt aus einem Grundkreis und einem Nockenberg besteht.

Wie in Fig. 2 ferner zu sehen ist, weist der Nocken 3 eine außenliegende Nockenlauffläche 6 auf. Durch eine Drehung der Welle 2 um die Drehachse 5 wird der Nocken 3 um die Drehachse 5 gedreht, wobei die Nockenlauffläche 6 entlang eines zu betätigenden Bauteiles, insbesondere eines Hebels, gleitet. Durch die exzentrische Ausbildung des Nockens 3 erfolgt hierbei eine Betätigung des zu betätigenden Bauteils, also insbesondere des Hebels. Um eine Reibung zwischen der Nockenlauffläche 6 und dem zu betätigenden Bauteil zu reduzieren, ist die Nockenlauffläche 6 mit amorphem Kohlenstoff, wie beispielsweise Diamond-like Carbon (DLC) beschichtet. Ferner ist die mit amorphem Kohlenstoff beschichtete Nockenlauffläche 6 feinstbearbeitet und insbesondere mit einem Superfinish-Verfahren behandelt, um Unebenheiten bzw. Spitzen der amorphen Kohlenstoffschicht zu beseitigen oder zumindest zu reduzieren.

Die Feinstbearbeitung kann beispielsweise durch Polieren und/oder Schleifen und/oder Honen und/oder durch Kugelstrahlen erfolgen.

Fig. 3 zeigt eine Seitenansicht des Nockens 3, bei der die Nockenlauffläche 6 zu sehen ist. Hierbei ist zu sehen, dass auf die Nockenlauffläche 6 eine Struktur 7, die insbesondere eine Mikrostruktur 8 sein kann, aufgebracht ist. Ferner ist zu sehen, dass die Struktur 7 bzw. Mikrostruktur 8 lediglich in einem Bereich 9 der Nockenlauffläche 6 aufgebracht ist. Die Struktur 7, insbesondere die Mikrostruktur 8, kann vor dem Beschichten der Lauffläche 6 mit amorphem Kohlenstoff oder im Anschluss daran oder wahlweise im Anschluss an die Feinstbearbeitung der Nockenlauffläche 6 aufgebracht worden sein. Bevorzugt wird die Nockenlauffläche 6, insbesondere der Bereich 9 mit der Struktur 7, insbesondere mit der Mikrostruktur 8, nach dem Aufbringen der Struktur 7 bzw. der Mikrostruktur 8, erneut feinstbearbeitet.

Bei der Struktur handelt es sich vorzugsweise um die Mikrostruktur 8. Die Struktur 7 weist mehrere linienartige Strukturelemente 10 auf, die jeweils eine Tiefe zwischen 2 µm und 20 µm aufweisen können. Hierbei berühren sich die Strukturelemente 10 teilweise und/oder schneiden sich. Durch die Struktur 7, insbesondere die Mikrostruktur 8, wird ein Speicher bzw. Reservoir für ein Schmiermittel geschaffen, das zwischen der Lauffläche 6 des Nockens 3 und dem zu betätigenden Bauteils gebracht werden kann, um die Reibung zu verringern bzw. das Gleitverhalten zu verbessern. Die Speicherung des Schmiermittels führt hierbei zu einer zusätzlichen Verringerung der Reibung bzw. zu einer zusätzlichen Verbesserung des Gleitverhaltens.

In der Fig. 3 ist weiterhin zu sehen, dass die Strukturelemente 10 der Struktur 7, insbesondere der Mikrostruktur 8, schräg zu einer Ausrichtung 11 des Nockens 3 bzw. schräg zur Achse 5 des Nockens 3 verlaufen. Dies dient insbesondere dem Zweck, eine bessere Speicherung von Schmiermitteln zu erreichen.

## Patentansprüche

1. Verfahren zur Herstellung/Bearbeitung eines Nockens (3) einer Nockenwelle (1), wobei
- der Nocken (3) eine Öffnung (4) zum Verbinden des Nockens (3) mit einer Welle (2) der Nockenwelle (1) aufweist,
- der Nocken (3) eine außenliegende Nockenlauffläche (6) aufweist,
- die Nockenlauffläche (6) zumindest bereichsweise mit amorphem
Kohlenstoff, insbesondere mit DLC, beschichtet wird,
**dadurch gekennzeichnet,**
**dass** die mit amorphem Kohlenstoff beschichtete Nockenlauffläche (6) durch eine Feinstbearbeitung, insbesondere mit einem Superfinish-Verfahren, bearbeitet wird.

2. Verfahren nach Anspruch 1,
**dadurch gekennzeichnet,**
**dass** die mit amorphem Kohlenstoff beschichtete Nockenlauffläche (6) bei der Feinstbearbeitung geschliffen und/oder gehont und/oder poliert und/oder durch ein Kugelstrahlen bearbeitet wird.

3. Verfahren nach Anspruch 1 oder 2,
**dadurch gekennzeichnet,**
**dass** auf die Nockenlauffläche (6) vor dem Beschichten mit amorphem Kohlenstoff zumindest bereichsweise eine Struktur (7), insbesondere eine Mikrostruktur (8), aufgebracht wird.

4. Verfahren nach einem der Ansprüche 1 bis 3,
**dadurch gekennzeichnet,**
**dass**
- auf die mit amorphem Kohlenstoff beschichtete Nockenlauffläche (6), und/oder
- auf die mit amorphem Kohlenstoff beschichtete und feinstbearbeitete
Nockenlauffläche (6),
zumindest bereichsweise eine Struktur (7), insbesondere eine Mikrostruktur (8), aufgebracht wird und die die Struktur (7) aufweisende Nockenlauffläche (6) feinstbearbeitet wird.

5. Verfahren nach Anspruch 3 oder 4,
**dadurch gekennzeichnet,**
**dass** die Struktur (7) mechanisch und/oder mittels einer Lasereinrichtung und/oder mittels einer Elektronenstrahleinrichtung aufgebracht wird.

6. Verfahren nach einem der Ansprüche 3 bis 5,
**dadurch gekennzeichnet,**
**dass** beim Aufbringen der Struktur (7) linienartige Strukturelemente (10) der Struktur (7) aufgebracht werden, die sich insbesondere kontaktieren und/oder schneiden.

7. Verfahren nach Anspruch 6,
**dadurch gekennzeichnet,**
**dass** die Strukturelemente (10) derart aufgebracht werden, dass sie schräg zu einer Achsrichtung (11) des Nockens (3), insbesondere in einem Winkel zwischen 60° und 90° zur Achsrichtung (11) des Nockens (3), verlaufen.

8. Verfahren nach einem der Ansprüche 1 bis 7,
**dadurch gekennzeichnet,**
**dass** die Feinstbearbeitung derart angewendet wird, dass eine Autokorrelationslänge (Sal) der mit der Feinstbearbeitung bearbeiteten Nockenlauffläche (6) vergrößert, insbesondere verdoppelt, wird.

9. Verfahren nach einem der Ansprüche 1 bis 8,
**dadurch gekennzeichnet,**
**dass** die Feinstbearbeitung derart angewendet wird, dass eine Spitzendichte der Oberfläche (Spd) der mit der Feinstbearbeitung bearbeitete Nockenlauffläche (6) verkleinert, insbesondere um mindestens 10 % verkleinert, wird.

10. Nocken (3) einer Nockenwelle (1), der gemäß einem Verfahren nach einem der vorherigen Ansprüche hergestellt/bearbeitet ist.
